# EUROPÄISCHE PATENTSCHRIFT

(11) **EP 4 476 758 B1**
(45) Veröffentlichungstag und Bekanntmachung des Hinweises auf die Patenterteilung: **13.08.2025**
(21) Anmeldenummer: 23703683.5
(22) Anmeldetag: 27.01.2023
(51) Int. Cl.: H01J 37/32

(54) **SYMMETRISCHER PROZESSREAKTOR**
SYMMETRICAL PROCESS REACTOR
RÉACTEUR DE TRAITEMENT SYMÉTRIQUE

(30) Priorität: 07.02.2022 DE 102022102768
(43) Veröffentlichungstag der Anmeldung: 18.12.2024
(73) Patentinhaber: Wege, Stephan, 01728 Bannewitz-Cunnersdorf (DE)
(72) Erfinder: Wege, Stephan, 01728 Bannewitz-Cunnersdorf (DE)
(74) Vertreter: Weisse, Moltmann & Willems PartGmbB
(86) Internationale Anmeldenummer: PCT/DE2023/100062
(87) Internationale Veröffentlichungsnummer: WO 2023/147814

(56) Entgegenhaltungen:
- EP-A1- 1 103 632
- US-A- 5 105 761
- US-A- 5 792 272
- US-A1- 2013 087 286
- US-A1- 2015 218 697
- US-B1- 6 182 602

## Beschreibung

### Technisches Gebiet

Die Erfindung betrifft einen Prozessreaktor zum Plasma-Ätzen mit atomarer Genauigkeit (ALE) eines zu bearbeitenden Substrats und/oder zur plasmaunterstützten Abscheidung (PEALD) von Atomlagen auf dem Substrat, enthaltend:
a) eine Reaktionskammer,
b) einen Tisch und/oder Halterung für das Substrat in der Reaktionskammer,
c) eine Gaszuführung, welche das Substrat gleichmäßig mit Gas in der Reaktionskammer benetzt, wobei
d) die Gaszuführung aus einem Gasinjektor besteht, der einen Leitungsring mit radialsymmetrisch und zur zentralen Achse zeigenden Düsen enthält, in dem das zu bearbeitende Substrat zentral angeordnet ist,
e) eine Pumpe zum Evakuieren der Reaktionskammer,
f) Mittel zur Erzeugung eines Plasmas in der Reaktionskammer
g) die Reaktionskammer rotationssymmetrischen ausgestaltet ist, wobei die Pumpe zentralsymmetrisch unterhalb des Tischs und/oder der Halterung an der Reaktionskammer angeordnet ist.

### Beschreibung

Solche Prozessreaktoren kommen in der Plasma-Ätztechnik (ALE) bzw. plasmaunterstützten Abscheidung (PEALD) von einzelnen Atomlagen auf einem Substrat zum Einsatz. Bei der Abscheidung werden die einzelnen Atomschichten auf dem Substrat, wie z.B. einem Halbleiter, mit dem ALD- (=Atomic Layer Disposition) bzw. mit dem PEALD-Verfahren (=Plasma Enhanced ALD) aufgebracht. Hierdurch können kleinste Strukturen bzw. Dotierungen auf einem Substrat, wie sie bei der industriellen Chipherstellung erforderlich sind, erzeugt werden.

In der PEALD-Technik reagiert das Substrat in einer sequentiellen Abfolge mit geeigneten Reaktionspartnern, auch "Precursor" genannt. Die sequentielle Abfolge erlaubt eine genaue Kontrolle der Schichtdicke der Atomlagen.

Das PEALD-Verfahren lässt sich vereinfacht wie folgt beschreiben: Zunächst wird die gereinigte Oberfläche des Substrats in der Reaktionskammer des Prozessreaktors einem ersten Reaktionspartner ausgesetzt (meist ohne Plasma). Bei dem Substrat handelt es sich oft um einen scheibenförmigen Halbleiter, auch Wafer genannt. Es ist hierbei erforderlich, dass die Adsorption an der Oberfläche durch einen selbstlimitierenden Prozess gesteuert wird. Die Wahl des geeigneten Precursors (Reaktionspartner) ist entscheidend. Damit wird vermieden, dass nicht mehr als eine Monolage des ersten Reaktionspartners, unabhängig von der Menge angebotenen Gases, adsorbiert wird. Anschließend werden die Reste des ersten Reaktionspartners aus der Reaktionskammer des Prozessreaktors gespült bzw. mit einer Pumpe abgepumpt. Dies verhindert eine Gasphasenreaktion mit einem zweiten Reaktionspartner. Letzterer wird in einem weiteren Schritt über die Substratoberfläche geleitet und bei der klassischen ALD über thermische Energie zur Reaktion gebracht. Danach ist in der Regel wiederum ein sogenannter Spülzyklus im Prozessreaktor erforderlich.

Die Reaktivität der Reaktionspartner mit dem Substrat kann signifikant erhöht werden, indem ein Plasma zum Einsatz kommt. Das Plasma entsteht durch z.B. die Wechselwirkung eines elektrischen Wechselfeldes in einem kapazitiv gekoppeltem System.

Bei diesem Verfahren ist es wünschenswert, dass die Reaktionspartner mit dem Substrat zeitlich und auch räumlich möglichst uniform bzw. gleichmäßig reagieren können. Die PEALD-Anlagentechnik ist naturgemäß komplex, da die Gasführungs- und andere flowdynamische Systeme auch der uniformen Einkopplung von RF-Leistung (RF=Hochfrequenz) entsprechen müssen.

Das Ätzen von Atomschichten ALE (=Atomic Layer Etching) ist eine Technik, bei der eine Abfolge zwischen möglichst selbstbegrenzenden chemischen Modifikationsschritten, die nur die obersten Atomschichten des Substrats betreffen, und Ätzschritten, die nur die chemisch modifizierten Bereiche entfernen, die Entfernung einzelner Atomschichten ermöglicht. Dieses Verfahren macht ein komplexes Gashandling für Abtragsraten einer Atomschicht erforderlich.

Für die PEALD Abscheidung und der ALE Ätzung in einem Prozessreaktor ist die Strömungsdynamik ein wichtiger Parameter insbesondere für die erforderliche Uniformität. Somit muss das Gas möglichst gleichmäßig und symmetrisch in die Reaktionskammer des Prozessreaktors eingebracht werden.

### Stand der Technik

Aus der DE 20 2016 108 845 A1 ist ein Gasinjektor für solche ALD, PEALD bzw. ALE-Prozessreaktoren bekannt. Der Gasinjektor ist als ringförmiger Grundkörper ausgebildet, wobei Einlassdüsen für das Gas symmetrisch zum Zentrum zeigend in dem Grundkörper angeordnet sind. Die Einlassdüsen werden einzeln oder in Gruppenverbünden über Gaszuführungen mit Gas beaufschlagt. Dazu ist wenigstens ein Bypass vorgesehen, um das Gas uniform an die Einlassdüsen zu bringen. Dadurch wird der Reaktionsbereich, in dem das Substrat angeordnet ist, zeitlich und räumlich gleichmäßig mit dem Reaktionspartner zur Reaktion in Kontakt gebracht.

Die EP 0552 491 B1 betrifft einen Plasmaätzprozess unter Einsatz von Hochfrequenz-Plasmaverarbeitungsreaktoren. Es wird insbesondere ein Plasmareaktor beschrieben, der eine Hochfrequenz-(HF)-Energiequelle verwendet, um die zugehörige elektromagnetische HF-Welle mit dem Plasma elektromagnetisch zu koppeln, wobei eine Siliziumquelle in Kontakt mit dem Plasma steht. Dabei werden Prozesse in einem solchen Reaktor durchgeführt.

Die DE 10 2020 107 215 A1 beschreibt ein Verfahren zum Verarbeiten eines Halbleiterwafers. Das Verfahren umfasst ein Laden eines Halbleiterwafers auf eine obere Fläche einer Wafer-Spannvorrichtung. Das Verfahren umfasst außerdem ein Zuführen eines gasförmigen Materials zwischen den Halbleiterwafer und die obere Fläche der Wafer-Spannvorrichtung durch eine erste Gaseinlassöffnung und eine zweite Gaseinlassöffnung, die unterhalb eines fächerförmigen Abschnitts der oberen Fläche angeordnet sind. Das Verfahren umfasst ferner ein Zuführen eines Fluidmediums in eine Fluideinlassöffnung der Wafer-Spannvorrichtung und Führen des Fluidmediums von der Fluideinlassöffnung, so dass es durch mehrere bogenförmige Kanäle fließt, die unterhalb des fächerförmigen Abschnitts der oberen Fläche angeordnet sind. Außerdem umfasst das Verfahren ein Zuführen eines Plasmagases über den Halbleiterwafer.

In der DE 10 2019 001 615 A1 wird ein plasmagestütztes CVD-Verfahren vorgestellt, bei dem die Energie zur Erzeugung des Plasmas nicht durch elektromagnetische Strahlung in den CVD-Reaktor eingekoppelt wird, sondern durch einen Explosionsvorgang Energie freigesetzt wird, die das Plasma letztendlich erzeugt. Dadurch entsteht innerhalb der Explosionszone ein Plasma mit schichtbildenden und wachstumsfördernden Reaktionsspezies, die mittels der sich von dem Explosionsort ausbreitenden Stoßfront auf die Substratoberfläche auftreffen, wo sich die abzuscheidende Dünnschicht ausbildet. Der Vorteil eines solchen Verfahrens ist eine Schichtabscheidung innerhalb einer sehr kurzen Zeitspanne. Eine uniforme Abscheidung an einem Substrat lässt sich aber nicht gut mit diesem Verfahren realisieren.

Die DE 11 2014 005 386 B4 bezieht sich auf ein Gasabscheidungssystem, das dazu ausgelegt ist, Plasmaaktivierte Atomschichtabscheidungs- (PEALD-) Gasabscheidungszyklen durchzuführen, die verwendbar sind, um Dünnfilm-Materialschichten auf freiliegenden Oberflächen eines Festkörpersubstrats abzuscheiden. Das PEALD-System enthält insbesondere eine Reaktionskammer, eine Hauptvakuumpumpe zum Herstellen eines ersten Vakuumdrucks in der Reaktionskammer während Nicht-Plasma-Precursor-Abscheidungszyklen und eine zweite Vakuumpumpe zum Herstellen eines zweiten niedrigeren Vakuumdrucks in der Reaktionskammer während Plasma-Precursor-Abscheidungszyklen.

Die WO 2007/042017 A1 betrifft eine Vorrichtung sowie ein Verfahren zur Plasmabehandlung von Objekten. Die Vorrichtung umfasst dabei eine Plasmakammer, in der zumindest eine Elektrode als Objektträger angeordnet ist. Weiterhin bildet zumindest ein Wandbereich der Plasmakammer und/oder zumindest ein in der Plasmakammer angeordnetes Bauteil eine Gegenelektrode. Mittels einer Hochfrequenzeinheit ist durch Anlegen einer hochfrequenten Wechselspannung zwischen Elektrode und Gegenelektrode ein Plasma in der Plasmakammer erzeugbar. Die Plasmakammer ist durch eine Trenneinrichtung in zumindest zwei Teilvolumina aufgeteilt, von denen ein erstes Teilvolumen für ein Reaktivgas die Elektrode und ein zweites Teilvolumen für ein Inertgas einen bei der Plasmaerzeugung aktiven Bereich der Gegenelektrode beinhalten. Die Trenneinrichtung ist derart ausgebildet, dass sie einen für die Erzeugung des Plasmas erforderlichen Elektronenaustausch im Plasma zwischen den Teilvolumina ermöglicht und als Diffusionssperre für das Reaktivgas wirken kann. Mit der Vorrichtung und dem zugehörigen Verfahren können durch die Plasmabehandlung hervorgerufene Niederschläge auf der Gegenelektrode vermindert werden.

In der US 5 792 272 A wird ein durch Plasma unterstützter chemischer Prozessreaktor beschrieben. Der Reaktor umfasst eine Plasmakammer mit einem ersten Gasinjektionsverteiler und einer Quelle elektromagnetischer Energie. Die Plasmakammer steht in Verbindung mit einer Prozesskammer, die eine Wafer-Halterung und einen zweiten Gasverteiler enthält. Das in der Plasmakammer erzeugte Plasma erstreckt sich in die Prozesskammer und interagiert mit den reaktiven Gasen, um eine Materialschicht auf dem Wafer abzusetzen. Der Reaktor verfügt außerdem über ein Vakuumsystem zum Absaugen des Reaktors. Das Verfahren umfasst die Schritte der Plasmagenerierung in der Plasmakammer, des Einleitens von mindestens einem gasförmigen chemischen Stoff in die Prozesskammer in der Nähe der Wafer-Halterung und der Anwendung eines HF-Gradienten, um die Diffusion des Plasmas in den Bereich nahe der Wafer-Halterung zu fördern.

Die US 2015/218697 bezieht sich allgemein auf Vorrichtungen und Verfahren zur Symmetrie im elektrischen Feld, Gasfluss und in der thermischen Verteilung in einer Verarbeitungskammer, um Prozessgleichmäßigkeit zu erreichen. Eine Ausführungsform der umfasst eine Plasmaverarbeitungskammer mit einer Plasmaquelle, einer Substratstützanordnung und einer Vakuumpumpe, die entlang derselben zentralen Achse ausgerichtet sind, um weitgehend symmetrische Flusswege, elektrische Felder und eine thermische Verteilung in der Plasmaverarbeitungskammer zu erzeugen, was zu einer verbesserten Prozessgleichmäßigkeit und reduzierter Verzerrung führt.

Aus der US 6 182 602 B1 ist ein HDP-CVD-Werkzeug bekannt, das gleichzeitig dotiertes und undotiertes Siliziumdioxid ablagert und sputtert und dadurch eine hervorragende Spaltfüllung sowie die flächige Abscheidung auf Wafern ermöglicht. Das Werkzeug umfasst eine induktiv gekoppelte Plasmquelle mit zwei RF-Zonen. Ferner ist ein zweizoniges Gasverteilungssystem vorgesehen. Die Oberflächen innerhalb des Werkzeugs sind temperaturgesteuert. Weiterhin ist ein symmetrisch geformtes, turbomolekular gepumptes Kammergehäuse vorgesehen. Ein elektrostatischer Chuck weist zwei Kühlzonen auf. Die Kammer besteht aus Keramik/Aluminiumlegierung. Es ist bei diesem Werkzeug außerdem ein System zur Fernreinigung der Plasmakammer vorgesehen.

Ausführungsformen der US 2013/087286 A1 bieten ein Plasmakammer-Design, das eine extrem symmetrische elektrische, thermische und Gasfluss-Leitfähigkeit durch die Kammer ermöglicht. Durch diese Symmetrie weist das in der Kammer erzeugte Plasma eine verbesserte Gleichmäßigkeit über die Oberfläche eines im Verarbeitungsbereich der Kammer angeordneten Substrats auf. Zudem ermöglichen zusätzliche Kammerfunktionen, wie die Anpassung des Abstands zwischen oberen und unteren Elektroden sowie zwischen einem Gaseinlass und dem zu verarbeitenden Substrat, eine bessere Kontrolle der Plasmaverarbeitung und Gleichmäßigkeit im Vergleich zu herkömmlichen Systemen. Bei dieser Plasmakammer kommt ein Duschkopf als Gasinjektor zum Einsatz. Beim Duschkopf lässt sich das Substrat nur bedingt gleichmäßig mit dem abzuscheidenden bzw. ätzenden Gas benetzen.

Die EP 1 103 632 A1 beschreibt eine Vorrichtung zur Abscheidung eines Films auf einem Substrat bereit, die eine Verarbeitungskammer, ein Substrat-Trägerelement in der Kammer, einen ersten Gaseinlass, einen zweiten Gaseinlass, einen Plasmagenerator und einen Gasabzug umfasst. Der erste Gaseinlass führt ein erstes Gas in einem ersten Abstand von einer Innenfläche der Kammer zu, während der zweite Gaseinlass ein zweites Gas in einem geringeren Abstand zur Innenfläche der Kammer zuführt. Dadurch erzeugt das zweite Gas einen höheren Partialdruck nahe der Innenfläche der Kammer, um die Abscheidung des ersten Gases auf dieser Innenfläche deutlich zu reduzieren. Die Konstruktion der Kammer und der Gaszufuhr, einschließlich eines speziellen Ringsystems, sorgt für elektrische und thermische Symmetrie, wodurch Störungen des elektrischen Feldes minimiert werden. Ein weiteres Merkmal ist die Bewegungssteuerung der unteren Elektrode, die eine variable Distanz zur oberen Elektrode ermöglicht und so die Plasmaparameter präzise beeinflussen kann. Temperaturkontrollierte Auskleidungskomponenten und die strukturierte Anordnung von Gasrohren verbessern die Prozesskonsistenz und die Haltbarkeit der Vorrichtung. Zu- und Ableitungen können innerhalb der Verarbeitungskammer zu Verwirbelungen der eingelassenen Gase führen, wodurch die Gleichmäßigkeit bei der Abscheidung bzw. beim Ätzen beeinträchtigt werden kann.

Die bekannten ALD-, PEALD- und ALE-Anlage haben den Nachteil, dass die zu behandelnden Substrate über Ihre Oberfläche nicht uniform mit ihrem Reaktionspartner in Kontakt kommen. Ursächlich ist eine Ungleichverteilung des jeweils reagierenden Gases in der Reaktionskammer.

### Offenbarung der Erfindung

Aufgabe der Erfindung ist es daher, die Nachteile des Standes der Technik zu vermeiden und einen Prozessreaktor zu schaffen, der eine Uniformität bei der Benetzung der Oberfläche des Substrats mit dem jeweiligen Reaktionspartner bzw. Precursor ermöglicht.

Erfindungsgemäß wird die Aufgabe dadurch gelöst, dass bei einem Prozessreaktor zum Plasma-Ätzen (ALE) mit atomarer Genauigkeit eines zu bearbeitenden Substrats und/oder zur plasmaunterstützten Abscheidung von Atomlagen auf dem Substrat der eingangs genannten Art
h) wenigstens ein rohrförmiger Profilkörper zur Positionierung des Tischs und/oder der Halterung in der Reaktionskammer oberhalb der Pumpe vorgesehen ist, wobei
i) wenigstens eine Versorgungsleitung von außerhalb der Reaktionskammer zu dem Tisch und/oder zu der Halterung durch den rohrförmigen Profilkörper geführt ist und wobei
j) ein ringförmiger Staudruckerzeuger zur Begrenzung der Ausdehnung des in der Reaktionskammer erzeugten Plasmas vorgesehen ist.

Die bekannten ALD-, PEALD- und ALE-Anlage bzw. -Systeme haben versucht die Uniformität des Gases als Reaktionspartners dadurch zu erzielen, dass sie den Gaseinlass, optimiert haben. Die Erfindung beruht auf dem Prinzip nicht nur den Gaseintritt in die Reaktionskammer, sondern auch den Gasaustritt aus der Reaktionskammer zu betrachten. Überraschenderweise hat sich gezeigt, dass die Strömungsverhältnisse in der Prozesskammer ganz wesentlich auch von der Ausgestaltung der Reaktionskammer und der Lage der evakuierenden Pumpe abhängen. Das Zusammenspiel von Rotationssymmetrie der Reaktionskammer und der zentral daran angeordneten Pumpe sorgt im Betrieb der Anlage für eine uniforme Strömung im Bereich der Oberfläche des Substrats. Die Pumpe ist dabei unterhalb des Tischs und/oder der Halterung angeordnet. Auf diese Weise ist es möglich, gleichmäßig und uniform die Strömung auch beim Evakuieren in der Reaktionskammer zu gewährleisten. Durch das Plasma können zahlreiche Prozesse bzw. Reaktionen beschleunigt werden. Dabei sollte auch das Plasma eine möglichst optimierte Uniformität aufweisen, um einen gleichförmigen und damit u.a. gut reproduzierbaren Prozess zu erhalten.

Eine Ausgestaltung des erfindungsgemäßen Prozessreaktors zum Plasma-Ätzen (ALE) mit atomarer Genauigkeit eines zu bearbeitenden Substrats und/oder zur plasmaunterstützten Abscheidung von Atomlagen auf dem Substrat besteht darin, dass wenigstens ein rohrförmiger Profilkörper zur Positionierung des Tischs und/oder der Halterung in der Reaktionskammer oberhalb der Pumpe vorgesehen ist. Eine uniforme Strömung innerhalb der Reaktionskammer ist enorm wichtig, damit der Reaktionspartner gleichmäßig mit dem Substrat über seine gesamte Oberfläche reagieren kann. Die rohrförmigen Profilkörper bilden eine Form, die einen optimierten Strömungsverlauf erlauben. Dabei liegt der Tisch bzw. die Halterung oberhalb der Pumpe, welche für die Evakuierung der Reaktionskammer erforderlich ist.

In der Ausgestaltung des erfindungsgemäßen Prozessreaktors zum Plasma-Ätzen (ALE) mit atomarer Genauigkeit eines zu bearbeitenden Substrats und/oder zur plasmaunterstützten Abscheidung von Atomlagen auf dem Substrat ist wenigsten eine Versorgungsleitung von außerhalb der Reaktionskammer zu dem Tisch und/oder zu der Halterung durch den rohrförmigen Profilkörper geführt. Zuleitungen oder Ableitungen sind zur Versorgung mit Ressourcen bzw. Abführung von Resten am Tisch oder dem Substrat erforderlich. Bisher störten sie den Uniformen Strömungsverlauf. Die Versorgungsleitungen sind daher in dem rohrförmigen Profilkörper verlegt und erzeugen somit keine zusätzlichen unerwünschten Verwirbelungen in der uniformen Strömung.

Eine weitere bevorzugte Ausbildung des erfindungsgemäßen Prozessreaktors ergibt sich dadurch, dass in dem Anschlussbereich des rohrförmigen Profilkörpers zum Tisch und/oder der Halterung ein Durchlass, insbesondere für die Versorgungsleitung, vorgesehen ist. Um die Versorgungsleitung über den Tisch bzw. der Halterung zu führen sind wenigstens ein Durchlass in dem Tisch bzw. der Halterung vorgesehen. Diese Maßnahme dient dazu, dass die Leitungen, für z.B. Gas, Kühlung oder Sensoren, nicht um den Tisch bzw. die Halterung herumgeführt werden müssen. Dies würde nämlich nur zu unerwünschten Verwirbelungen führen.

In einer bevorzugten Ausbildung des erfindungsgemäßen Prozessreaktors zum Plasm-Ätzen (ALE) mit atomarer Genauigkeit eines zu bearbeitenden Substrats und/oder zur plasmaunterstützten Abscheidung von Atomlagen auf dem Substrat sind wenigstens sechs rohrförmige Profilkörper zur Positionierung des Tischs und/oder der Halterung in der Reaktionskammer radialsymmetrisch angeordnet.

Eine besonders vorteilhafte Ausgestaltung des erfindungsgemäßen Prozessrekordreaktors wird zudem dadurch erreicht, dass der Tisch und/oder die Halterung in der Reaktionskammer höhenverstellbar ausgebildet ist. Auf diese Weise kann das Substrat in eine optimale Position zur Gaszufuhr gebracht werden. Bei unterschiedlichen Substraten mit verschiedenen Schichtdicken können die Abstände zu der oberhalb des Substrats angeordneten Gaszufuhr optimiert ausgeglichen werden.

In einer weiteren vorteilhaften Ausgestaltung des erfindungsgemäßen Prozessreaktors ist das zu bearbeitende Substrat zentrisch in der rotationssymmetrischen Reaktionskammer angeordnet. Diese Maßnahme dient dazu, die Strömungsverhältnisse eines Gases als Reaktionspartner mit der rotationssymmetrischen Reaktionskammer in entsprechenden Einklang zu bringen. Hierdurch wird die Uniformität des Reaktionspartners im Bereich der Oberfläche des Substrats verbessert.

Ein weiterer Vorteil des erfindungsgemäßen Prozessreaktors ergibt sich dadurch, dass die Gaszuführung aus einem Gasinjektor besteht, der einen Leitungsring mit radialsymmetrisch und zur Zentrale Achse zeigenden Düsen enthält, in dem das zu bearbeitende Substrat zentral angeordnet ist.

In einer vorteilhaften Ausbildung des erfindungsgemäßen des Prozessreaktor zum Plasma-Ätzen mit atomarer Genauigkeit eines zu bearbeitenden Substrats und/oder zur plasmaunterstützten Abscheidung von Atomlagen auf dem Substrat weist der Leitungsring wenigstens einen Bypass zur gleichmäßigen Versorgung der Düsen auf. Die Strömungsverhältnisse des Reaktionspartners hängt auch davon ab, dass das Gas gleichmäßig aus den Düsen des Gasinjektors austritt. Im Bereich der Düsen des Gasinjektors kommt es u.a. zu Verwirbelungen im Leitungsring. Dadurch können die Gasdrücke an den Düsen unterschiedlich sein. Um die Düsen mit möglichst gleichen Gasdrücken zu beaufschlagen ist wenigstens ein Bypass-Kanal vorgesehen.

Ein weiterer Vorteil der Ausgestaltung des erfindungsgemäßen Prozessreaktors zum Plasma-Ätzen mit atomarer Genauigkeit eines zu bearbeitenden Substrats und/oder zur plasmaunterstützten Abscheidung von Atomlagen auf dem Substrat ergibt sich dadurch, dass ein Staudruckerzeuger vorgesehen ist. Der Staudruckerzeuger dient dazu, einen Staudruck beim reagierenden Gas zu erzeugen. Dies erhöht die Uniformität des Reaktionspartners im Bereich der Substratoberfläche. Dabei kann es sich bei dem Staudruckerzeuger um einen siebförmigen Metallring handeln, der als Nebeneffekt die Ausdehnung des Plasmas nur im Reaktionsbereich der Reaktionskammer hält. Hierdurch dient er somit auch als Plasmabegrenzer.

Eine bevorzugte und vorteilhafte Ausgestaltung des erfindungsgemäßen Prozessreaktors zum Plasma-Ätzen (ALE) mit atomarer Genauigkeit eines zu bearbeitenden Substrats und/oder zur plasmaunterstützen Abscheidung von Atomlagen auf dem Substrat wird dadurch erreicht, dass eine Vakuumschleuse zum Einführen des Substrats vorgesehen ist. Die Vakuumschleuse erlaubt es das Substrat in die Reaktionskammer einzubringen, ohne die gesamte Kammer bei jeder Bearbeitung neu evakuieren zu müssen. Dabei kann die Vakuumschleuse so ausgestaltet sein, dass sowohl Tisch bzw. Halterung als auch das Substrat durch die Vakuumschleuse zum Beschicken und Entladen der Reaktionskammer geführt werden können. Die Vakuumschleuse sollte dabei beispielsweise mit einer Klappe oder mit einem Schieber derart in der Reaktionskammer verdeckt sein, dass keine Verwirbelungen in der Reaktionskammer an der Öffnung im laufenden Betrieb entstehen können. Dadurch wird die Uniformität der Gasströmung zusätzlich noch unterstützt.

Weitere Ausgestaltungen und Vorteile ergeben sich aus dem Gegenstand der Unteransprüche sowie den Zeichnungen mit den dazugehörigen Beschreibungen. Ausführungsbeispiele sind nachstehend unter Bezugnahme auf die beigefügten Zeichnungen näher erläutert. Dabei können zudem räumlich relative Begriffe, wie z.B. "unterhalb", "unter", "unterer", "oberhalb", "oberer" und dergleichen, im vorliegenden Text verwendet werden, um die Beschreibung zu vereinfachen, um die Beziehung eines Elements oder Strukturelements zu einem oder mehreren anderen Elementen oder Strukturelementen zu beschreiben, wie in den Figuren veranschaulicht. Die räumlich relativen Begriffe sollen neben der in den Figuren gezeigten Ausrichtung noch weitere Ausrichtungen der Vorrichtung während des Gebrauchs oder Betriebes umfassen. Die Vorrichtung kann auch anders ausgerichtet (90 Grad gedreht oder anders ausgerichtet) sein, und die im vorliegenden Text verwendeten räumlich relativen Deskriptoren können gleichermaßen entsprechend interpretiert werden.

Die Erfindung soll nicht alleine auf diese aufgeführten Ausführungsbeispiele beschränkt werden. Sie dienen lediglich zur näheren Erläuterung der Erfindung. Die vorliegende Erfindung soll sich auf alle Gegenstände beziehen, die unter den Schutzumfang der Ansprüche fällt, die die Erfindung definieren.

### Kurze Beschreibung der Zeichnung

- Fig. 1: zeigt als schematische Prinzipskizze einen vertikalen Schnitt eines erfindungsgemäßen Prozessreaktors zur Abscheidung von Atomlagen auf einem Substrat.
- Fig. 2: zeigt als schematische Prinzipskizze einen horizontalen Schnitt durch den erfindungsgemäßen Prozessreaktor gemäß der Figur 1.

### Bevorzugtes Ausführungsbeispiel

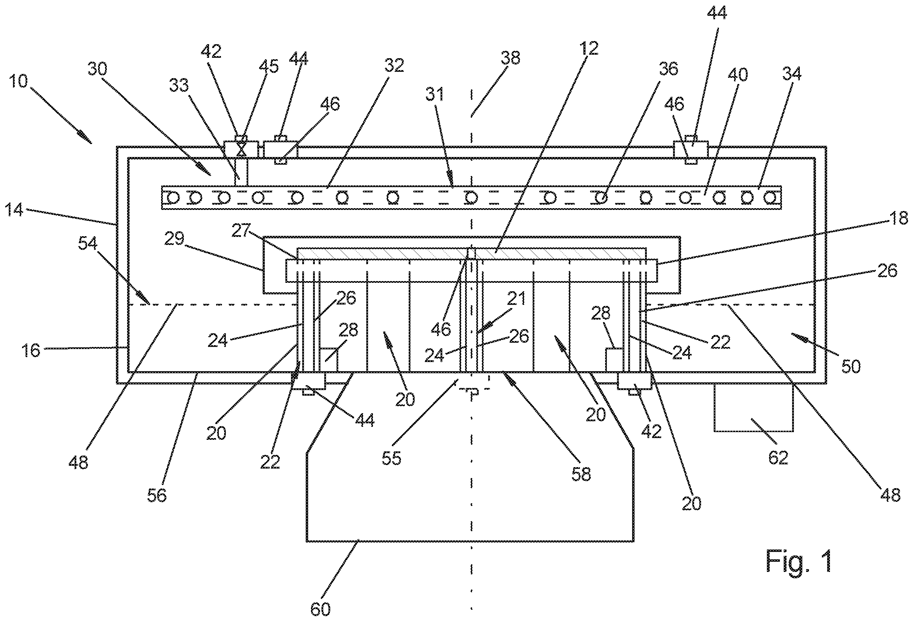

In Fig. 1 wird schematisch in einer Prinzipskizze der vertikale Schnitt eines erfindungsgemäßen Prozessreaktor 10 zum Plasma-Ätzen (ALE) mit atomarer Genauigkeit eines Substrats 12 und/oder zur plasmaunterstützten Abscheidung von Atomlagen auf dem Substrat 12 dargestellt. Der Prozessreaktor 10 enthält in diesem Ausführungsbeispiel ein Schutzgehäuse 14, in welchem eine Reaktionskammer 16 vorgesehen ist. Während das Schutzgehäuse 14 eine nahezu beliebige geometrische Gestalt als Gehäusekörper aufweisen kann, ist die Reaktionskammer 16 rotationssymmetrisches ausgestaltet.

Im vorliegenden Ausführungsbeispiel ist Reaktionskammer 16 im Wesentlichen zylinderförmig ausgebildet. Grundsätzlich sind auch andere rotationssymmetrisches Geometrien der Reaktionskammer 16 denkbar, wie beispielsweise eine kegel- oder kugelförmige Reaktionskammer 16. Das Substrat 12 ist auf einem Tisch 18 zentral in einer Reaktionskammer 16 gehalten. Der Tisch 18 wird von sechs rohrförmigen Profilkörpern 20 getragen.

Die rohrförmigen Profilkörper 20 sind im Kern hohl, wodurch in ihnen ein Hohlraum 22 entsteht. Durch den Hohlraum 22 der rohrförmigen Profilkörper 20 sind Versorgungs- und Steuerleitungen 21, sowohl Zuleitungen 24 als auch Ableitungen 26, aus der Reaktionskammer 16 geführt. Die Zuleitungen 24 und Ableitungen 26 sind beispielsweise erforderliche elektrische Leitungen, Flüssigkeits- oder Gasleitungen. Diese Versorgungsleitungen 21 sind durch Durchlässe 27 in dem Tisch 18, geführt. Auf diese Weise können von außerhalb der Reaktionskammer 16 Ressourcen zentral und symmetrisch zu dem Substrat 12 zugeführt werden. Die rohrförmigen Profilkörper 20 sind höhenverstellbar ausgestaltet. Dies wird durch eine teleskopartige Struktur der rohrförmigen Profilköper 20 realisiert, die durch einen Antrieb 28 ihre Länge verändern können.

Das Substrat 12 wird zur Bearbeitung über eine Vakuumschleuse 29 in die Reaktionskammer 16 eingeführt, sowie auf dem Tisch 18 - auch "Chuck" genannt - zentral positioniert und fixiert. Durch die Vakuumsschleuse 28 wird das fertig verarbeitete Substrat 12 auch wieder aus der Reaktionskammer 16 entfernt.

In der Reaktionskammer 16 des Prozessreaktors 10 ist im oberen Bereich 30 eine Gaszuführung 31 vorgesehen. Die Gaszuführung 31 ist als ein Gasinjektor 32 ausgestaltet. Von außerhalb der Reaktionskammer 16 wird durch eine Gasleitung 33 ein Gas oder ein Gasgemisch zu dem Gasinjektor 32 geleitet. Der Gasinjektor 32 besteht aus einem Leitungsring 34, an dem zahlreiche Lavaldüsen 36 angeordnet sind. Der Mittelpunkt des ringförmigen Gasinjektors 32 liegt auf einer zentralen Achse 38 der Reaktionskammer 16. Dabei sind die Lavaldüsen 36 radialsymmetrisch um die zentrale Achse 38 angeordnet. Die Lavaldüsen 36 zeigen in diesem Ausführungsbeispiel zu der zentralen Achse 38 der Reaktionskammer 16. Zur Erzeugung einer gleichmäßigen und symmetrischen Verteilung des Reaktionsgases an den Lavaldüsen 36 ist wenigstens ein Kanal als Bypass 40 zum Leitungsring 34 vorgesehen.

Anschlüsse 42, 44 dienen zum Anschließen der Gasleitung 33, wie z.B. für Helium, und elektrischen Versorgungs- und Steuerungsleitungen 21 an den Prozessreaktor 10. Die zugeführte Gasmenge in den Gasinjektor 32 lässt sich über ein regelbares Steuerventil 45 regeln. Elektroden 46 werden mit hochfrequenter Hochspannung für die Erzeugung eines Plasmas über elektrische Zuleitungen 24 versorgt. Die Reaktivität der Reaktionspartner mit dem Substrat 12 wird signifikant erhöht, wenn ein Plasma zum Einsatz kommt. Das Plasma entsteht durch Zünden einer Gasentladung. Durch Pulsen der Plasmaleistung wird eine sequentielle Abfolge erreicht

Ein ringförmiger Staudruckerzeuger 48 ist im unteren Bereich 50, unterhalb des Tischs 18 vorgesehen. Bei dem Staudruckerzeuger 48 handelt es sich um ein Ringsieb 52, womit ein geerdeter Metallring mit zahlreichen engmaschigen Bohrungen 54 verstanden wird, durch die ein Gas evakuiert werden kann. Der Staudruckerzeuger 48 dient als Staudruckerzeuger für das in der Reaktionskammer 16 befindliche Gas und begrenzt gleichzeitig die Ausdehnung des in der Reaktionskammer 16 erzeugten Plasmas . Damit wirkt der Staudruckerzeuger 48 auch als Plasmabegrenzer. Durch den Staudruckerzeuger 48 wird zudem der untere Bereich 50 von dem oberen Bereich 30 strömungstechnisch weitestgehend entkoppelt. Über Anschluss 55 wird die Elektrode 46 mit hochfrequenter Hochspannung versorgt.

Die Reaktionskammer 16 weist an ihrem Boden 56 eine zentrale Öffnung 58 auf. An dieser zentralen Öffnung 58 ist eine Turbopumpe 60 zentralsymmetrisch angeflanscht. Die Leistung der Turbopumpe 60 wird von einer prozessorgesteuerten Steuereinheit 62 geregelt. Die Turbopumpe 60 dient der Evakuierung der Reaktionskammer 16. Die Turbopumpe 60 sorgt dafür, dass die Reaktionskammer 16 permanent im Niederdruckbereich arbeitet.

Die rotationssymmetrische Reaktionskammer 16 und die entsprechend symmetrischen Anordnungen der Komponenten für die Gaszuführung und die Evakuierung des Gases als Reaktionspartner für das Substrat 12 erlauben eine extrem gleichmäßige Strömungsverteilung im Bereich des zentralsymmetrisch angeordneten Substrats 12. Diese gewünschte gleichmäßige Verteilung liefert im Ergebnis eine ebenso gleichmäßige Reaktion des Gases als Reaktionspartner mit dem Substrat 12.

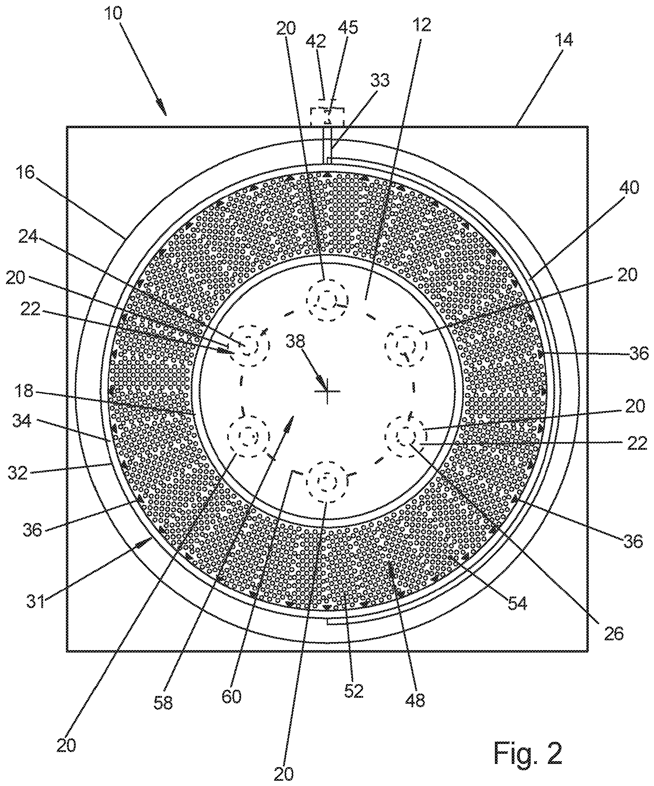

Figur 2 zeigt als schematische Prinzipskizze einen horizontalen Schnitt durch den erfindungsgemäßen Prozessreaktor 10 gemäß der Figur 1. Soweit sich die Bestandteile der beiden Figuren entsprechen, werden auch die gleichen Bezugszeichen verwendet. Wie in dieser Abbildung von Figur 2 sehr deutlich wird, sind die Komponenten rotationssymmetrisch um die zentrale Achse 38 angeordnet. Die Reaktionskammer 16 ist in dem Schutzgehäuse 14 vorgesehen.

In der Reaktionskammer 16 ist der Gasinjektor 32 um die Achse 38 zentriert angeordnet. An dem Leitungsring 34 sind die Lavaldüsen 36 vorgesehen. Ein Teil der Lavaldüsen 36 ist einerseits von dem Leitungsring 34 und andererseits von dem Bypass 40 mit Gas beaufschlagt. Der Gasinjektor 32 wird im vorliegenden Ausführungsbeispiel von der einzelnen Gaszuleitung 33, welche mit dem Gasanschluss 42 verbunden ist, mit einem Gas oder einem Gasgemisch als Reaktionspartner beschickt. Die Gasmenge, die über den Gasanschluss 42 zum Gasinjektor 32 geführt wird, wird über das Steuerungsventil 45 reguliert.

Der Tisch 18, auf dem das Substrat 12 fixiert ist, wird von den sechs rohrförmigen Profilkörpern 20 getragen. Sowohl der Tisch 18 bzw. Chuck, als auch das Substrat 12 sind zentral in der Reaktionskammer 16 unterhalb des Gasinjektors 32 positioniert. Die Profilkörper 20 sind ebenfalls radialsymmetrisch um die Achse 38 angeordnet.

Durch die Profilkörper 20 sind die Zuleitungen 24 und gegebenenfalls auch Ableitungen 26 geführt. Bei den Zuleitungen 24 handelt es sich um Gasleitungen, durch welche beispielsweise das Gas Helium transportiert wird oder elektrische Leitungen, über welche die Elektrode mit Hochspannung versorgt wird. Diese Leitungen sind bei Bedarf zur Vermeidung von elektrischen Überschlägen durch die Hochspannung ausreichend stark isoliert. Auch nicht dargestellte Heizungselemente werden über solche Zuleitungen 24 mit Spannung versorgt. Bei den Ableitungen 26 kann es sich z.B. um Signalleitungen handeln, über die Signale von nicht dargestellten Sensoren oder Steuerungssignale für diverse Komponenten übermittelt werden.

In dieser horizontalen Schnittdarstellung lässt sich gut die maschenartige Struktur des Staudruckerzeugers 48 erkennen. Der Staudruckerzeuger 48 wird durch das geerdete metallische Ringsieb 52 mit seinen Bohrungen 52 gebildet. Der Staudruckerzeuger 48 verhindert ferner eine unerwünschte Ausdehnung des Plasmas. Durch den Staudruck, den der Staudruckerzeuger 48 für ein zu evakuierendes Gas oder Gasgemisch erzeugt, wird die Uniformität der Strömung im oberen Bereich 30 optimiert. Wie sich die Strömung unterhalb des Staudruckerzeugers 48 verhält, ist für die Reaktion des Substrats 12 mit einem Gas als Reaktionspartner weitestgehend vernachlässigbar.

Die Turbopumpe 60 evakuiert die Reaktionskammer 16. Durch die zentralsymmetrische Anordnung der Turbopumpe 60 an dem Boden 56 der Reaktionskammer 16 wird das Gas bzw. Gasgemisch symmetrisch durch die zentrale Öffnung 58 in die Turbopumpe 60 gesaugt. Dabei sind die radialsymmetrischen Strömungsverläufe des Gases bzw. Gasgemisches alle in etwa gleich, wodurch eine optimierte Uniformität der Strömungsverläufe im Bereich des Substrats 12 im Wesentlichen gewährleistet werden kann. Die symmetrischen Strömungsverläufe werden nur durch die radialsymmetrischen Anordnungen der Komponenten, sowie der rotationssymmetrischen Reaktionskammer 16 und der zentralsymmetrisch befestigten Turbopumpe 60 erreicht.

### Bezugszeichenliste

| | | | |
|---|---|---|---|
| 10 | Prozessreaktor | 52 | Ringsieb |
| 12 | Substrat | 54 | Bohrungen |
| 14 | Schutzgehäuse | 56 | Boden |
| 16 | Reaktionskammer | 58 | zentralen Öffnung |
| 18 | Tisch | 60 | Turbopumpe |
| 20 | rohrförmigen Profilkörper | 62 | Steuereinheit |
| 21 | Versorgungs- und Steuerleitungen | | |
| 22 | Hohlraum | | |
| 24 | Zuleitungen | | |
| 26 | Ableitungen | | |
| 27 | Durchlass | | |
| 28 | Antrieb | | |
| 29 | Vakuumschleuse | | |
| 30 | oberer Bereich | | |
| 31 | Gaszuführung | | |
| 32 | Gasinjektor | | |
| 33 | Gasleitung | | |
| 34 | Leitungsring | | |
| 36 | Lavaldüsen | | |
| 38 | Zentrale Achse | | |
| 40 | Bypass-Kanal | | |
| 42 | Gasanschluss | | |
| 44 | Anschluss | | |
| 45 | regelbares Steuerventil | | |
| 46 | Elektroden | | |
| 48 | Staudruckerzeuger | | |
| 50 | unterer Bereich | | |

## Patentansprüche

1. Prozessreaktor (10) zum Plasma-Ätzen mit atomarer Genauigkeit eines zu bearbeitenden Substrats (12) und/oder zur plasmaunterstützten Abscheidung von Atomlagen auf dem Substrat (12), enthaltend:
a) eine Reaktionskammer (16),
b) einen Tisch (18) und/oder Halterung für das Substrat (12) in der Reaktionskammer (16),
c) eine Gaszuführung (31), welche das Substrat (12) gleichmäßig mit Gas in der Reaktionskammer (12) benetzt, wobei
d) die Gaszuführung (31) aus einem Gasinjektor (32) besteht, der einen Leitungsring (34) mit radialsymmetrisch und zur zentralen Achse (38) zeigenden Düsen (36) enthält, in dem das zu bearbeitende Substrat (12) zentral angeordnet ist,
e) eine Pumpe (60) zum Evakuieren der Reaktionskammer (16),
f) Mittel (46) zur Erzeugung eines Plasmas in der Reaktionskammer (16),
g) die Reaktionskammer (16) rotationssymmetrisch ausgestaltet ist, wobei die Pumpe (60) zentralsymmetrisch unterhalb des Tischs (18) und/oder der Halterung an der Reaktionskammer (16) an ihrem Boden (56) an einer zentralen Öffnung (58) angeordnet ist,
**dadurch gekennzeichnet, dass**
h) wenigstens ein rohrförmiger Profilkörper (20) zur Positionierung des Tischs (18) und/oder der Halterung in der Reaktionskammer (16) oberhalb der Pumpe (60) vorgesehen ist, wobei
i) wenigstens eine Versorgungsleitung (21) von außerhalb der Reaktionskammer (16) zu dem Tisch (18) und/oder zu der Halterung durch den rohrförmigen Profilkörper (20) geführt ist und wobei
j) ein ringförmiger Staudruckerzeuger (48) zur Begrenzung der Ausdehnung des in der Reaktionskammer (16) erzeugten Plasmas vorgesehen ist.

2. Prozessreaktor (10) zum Plasma-Ätzen mit atomarer Genauigkeit eines zu bearbeitenden Substrats (12) und/oder zur plasmaunterstützten Abscheidung von Atomlagen auf dem Substrat (12) nach Anspruch 1, wobei in dem Anschlussbereich des rohrförmigen Profilkörpers (20) zum Tisch (18) und/oder der Halterung ein Durchlass (27), insbesondere für die Versorgungsleitung (21), vorgesehen ist.

3. Prozessreaktor (10) zum Plasma-Ätzen mit atomarer Genauigkeit eines zu bearbeitenden Substrats (12) und/oder zur plasmaunterstützten Abscheidung von Atomlagen auf dem Substrat (12) nach einem der Ansprüche 1 bis 2, wobei wenigstens sechs rohrförmige Profilkörper (20) zur Positionierung des Tischs (18) und/oder der Halterung in der Reaktionskammer (16) radialsymmetrisch angeordnet sind.

4. Prozessreaktor (10) zum Plasma-Ätzen mit atomarer Genauigkeit eines zu bearbeitenden Substrats (12) und/oder zur plasmaunterstützten Abscheidung von Atomlagen auf dem Substrat (12) nach einem der Ansprüche 1 bis 3, wobei der Tisch (18) und/oder die Halterung in der Reaktionskammer (16) höhenverstellbar ausgebildet ist.

5. Prozessreaktor (10) zum Plasma-Ätzen mit atomarer Genauigkeit eines zu bearbeitenden Substrats (12) und/oder zur Plasmaunterstützten Abscheidung von Atomlagen auf dem Substrat (12) nach einem der vorherigen Ansprüche, wobei das zu bearbeitende Substrat (12) zentrisch in der rotationssymmetrischen Reaktionskammer (16) angeordnet ist.

6. Prozessreaktor (10) zum Plasma-Ätzen mit atomarer Genauigkeit eines zu bearbeitenden Substrats (12) und/oder zur plasmaunterstützten Abscheidung von Atomlagen auf dem Substrat (12) nach einem der Ansprüche 1 bis 5, wobei der Leitungsring (34) wenigstens einen Bypass (40) zur gleichmäßigen Versorgung der Düsen (36) aufweist.

7. Prozessreaktor (10) zum Plasma-Ätzen mit atomarer Genauigkeit eines zu bearbeitenden Substrats (12) und/oder zur plasmaunterstützten Abscheidung von Atomlagen auf dem Substrat (12) nach einem der Ansprüche 1 bis 6, wobei eine Vakuumschleuse (29) zum Einführen des Substrats (12) vorgesehen ist.

## Claims

1. Process reactor (10) for atomic-precision plasma etching of a substrate (12) and/or for plasma-enhanced atomic-layer deposition on the substrate (12), comprising:
a) a reaction chamber (16),
b) a table (18) and/or holder for the substrate (12) in the reaction chamber (16),
c) a gas inlet (31) which uniformly wets the substrate (12) with gas in the reaction chamber (16), wherein
d) the gas inlet (31) comprises a gas injector (32) having a supply ring (34) with radially-symmetrical nozzles (36) pointing toward the central axis (38), in which the substrate (12) to be processed is centrally arranged,
e) a pump (60) for evacuating the reaction chamber (16),
f) means (46) for generating a plasma in the reaction chamber (16),
g)the reaction chamber (16) being rotationally symmetric, wherein the pump (60) is arranged centrally beneath the table (18) and/or holder at the bottom (56) of the reaction chamber (16) at a central opening (58),
**characterized in that**
h) at least one tubular profile member (20) for positioning the table (18) and/or holder in the reaction chamber (16) above the pump (60) is provided,
i) at least one supply line (21) from outside the reaction chamber (16) to the table (18) and/or holder is guided through the tubular profile member (20), and wherein
j) a ring-shaped pressure baffle (48) for limiting the expansion of the plasma generated in the reaction chamber (16) is provided.

2. Process reactor (10) for atomic-precision plasma etching of a substrate (12) and/or for plasma-enhanced atomic-layer deposition on the substrate (12) according to claim 1,
**wherein**
a passage (27), in particular for the supply line (21), is provided in the connection region of the tubular profile member (20) to the table (18) and/or holder.

3. Process reactor (10) for atomic-precision plasma etching of a substrate (12) and/or for plasma-enhanced atomic-layer deposition on the substrate (12) according to one of claims 1 to 2,
**wherein**
at least six tubular profile members (20) for positioning the table (18) and/or holder in the reaction chamber (16) are arranged radially symmetrically.

4. Process reactor (10) for atomic-precision plasma etching of a substrate (12) and/or for plasma-enhanced atomic-layer deposition on the substrate (12) according to one of claims 1 to 3,
**wherein**
the table (18) and/or holder in the reaction chamber (16) is height-adjustable.

5. Process reactor (10) for atomic-precision plasma etching of a substrate (12) and/or for plasma-enhanced atomic-layer deposition on the substrate (12) according to one of the preceding claims,
**wherein**
the substrate (12) to be processed is arranged centrally in the rotationally symmetric reaction chamber (16).

6. Process reactor (10) for atomic-precision plasma etching of a substrate (12) and/or for plasma-enhanced atomic-layer deposition on the substrate (12) according to one of claims 1 to 5,
**wherein**
the supply ring (34) comprises at least one bypass (40) for uniform distribution of gas to the nozzles (36).

7. Process reactor (10) for atomic-precision plasma etching of a substrate (12) and/or for plasma-enhanced atomic-layer deposition on the substrate (12) according to one of claims 1 to 6,
**wherein**
a vacuum lock (29) for introducing the substrate (12) is provided.

## Revendications

1. Réacteur de procédé (10) pour la gravure plasma à précision atomique d'un substrat à usiner (12) et/ou pour le dépôt assisté par plasma de couches atomiques sur le substrat (12), comprenant :
a) une chambre de réaction (16),
b) une table (18) et/ou un support pour le substrat (12) dans la chambre de réaction (16),
c) une arrivée de gaz (31) qui imprègne uniformément le substrat (12) de gaz dans la chambre de réaction (16),
d) ladite arrivée de gaz (31) formée d'un injecteur de gaz (32) comportant une bague de distribution (34) munie de buses (36) disposées de façon radiale et orientées vers l'axe central (38), dans laquelle le substrat (12) à usiner est centré,
e) une pompe (60) pour évacuer la chambre de réaction (16),
f) des moyens (46) de génération d'un plasma dans la chambre de réaction (16),
g) la chambre de réaction (16) ayant une géométrie de révolution, la pompe (60) étant placée de façon centrée sous la table (18) et/ou le support au niveau du fond (56) de la chambre, par une ouverture centrale (58),
**caractérisé en ce que**
h) au moins un profilé tubulaire (20) destiné à positionner la table (18) et/ou le support dans la chambre de réaction (16) au-dessus de la pompe (60) est prévu,
i) au moins une conduite d'alimentation (21) venant de l'extérieur de la chambre de réaction (16) vers la table (18) et/ou le support est guidée à travers le profilé tubulaire (20), et
j) un générateur de contre-pression annulaire (48) pour limiter l'expansion du plasma généré dans la chambre de réaction (16) est prévu.

2. Réacteur de procédé (10) selon la revendication 1,
**dans lequel**
une ouverture de passage (27), notamment pour la conduite d'alimentation (21), est aménagée dans la zone de jonction du profilé tubulaire (20) avec la table (18) et/ou le support.

3. Réacteur de procédé (10) selon l'une quelconque des revendications 1 à 2,
**dans lequel**
au moins six profilés tubulaires (20) destinés à positionner la table (18) et/ou le support dans la chambre de réaction (16) sont disposés de façon radiale symétrique.

4. Réacteur de procédé (10) selon l'une quelconque des revendications 1 à 3,
**dans lequel**
la table (18) et/ou le support dans la chambre de réaction (16) est réglable en hauteur.

5. Réacteur de procédé (10) selon l'une quelconque des revendications précédentes,
**dans lequel**
le substrat (12) à usiner est disposé de manière centrée dans la chambre de réaction (16) de géométrie rotationnelle symétrique.

6. Réacteur de procédé (10) selon l'une quelconque des revendications 1 à 5,
**dans lequel**
la bague de distribution (34) comporte au moins une dérivation (40) assurant l'alimentation uniforme des buses (36).

7. Réacteur de procédé (10) selon l'une quelconque des revendications 1 à 6,
**dans lequel**
une sas à vide (29) pour l'introduction du substrat (12) est
